# EUROPÄISCHE PATENTSCHRIFT

(11) **EP 2 625 247 B1**
(45) Veröffentlichungstag und Bekanntmachung des Hinweises auf die Patenterteilung: **30.11.2016**
(21) Anmeldenummer: 11761009.7
(22) Anmeldetag: 16.09.2011
(51) Int. Cl.: C09K 11/77, H01L 33/50

(54) **MN-AKTIVIERTE LEUCHTSTOFFE**
MN-ACTIVATED PHOSPHORS
LUMINOPHORES ACTIVÉS PAR MN

(30) Priorität: 06.10.2010 DE 102010047474
(43) Veröffentlichungstag der Anmeldung: 14.08.2013
(73) Patentinhaber: Merck Patent GmbH, 64293 Darmstadt (DE)
(72) Erfinder: WINKLER, Holger, 64291 Darmstadt (DE); JUESTEL, Thomas, 58455 Witten (DE); BLEISE, Andre, 61161 Münster (DE)
(86) Internationale Anmeldenummer: PCT/EP2011/004652
(87) Internationale Veröffentlichungsnummer: WO 2012/045393

(56) Entgegenhaltungen:
- WO-A1-2007/144060
- DE-A1-102006 054 331
- DE-U1- 29 820 384
- US-A- 4 138 530
- US-A1- 2003 178 632

## Beschreibung

Die Erfindung betrifft Mn⁴⁺-aktivierte Leuchtstoffe, Verfahren zur Herstellung dieser Verbindungen und deren Verwendung als Konversionsleuchtstoffe bzw. in Leuchtmitteln.

Lumineszierende Materialien werden in Fluoreszenzlichtquellen, emissiven Bildschirmen und als Szintillatorkristalle für die Konversion von nicht sichtbarer Strahlung oder Hochenergiepartikeln in sichtbares Licht verwendet. Eine Materialklasse, die weite Verbreitung für diese Aufgabe gefunden hat, sind die Ce³⁺ dotierten Granate, insbesondere Y₃Al₅O₁₂:Ce (YAG) und (Gd₁₋ₓYₓ)₃(Al_{1-y}Ga_{y})₅O₁₂:Ce (YAGaG:Ce), wobei weitere Dotierungen, wie Lu³⁺ oder Tb³⁺, zur Optimierung des Spektrums verwendet wurden.

Schon 1996, d.h. kurz nach der technischen Realisierung von blauen InGaN LEDs mit hoher Energieeffizienz und einem Lichtstrom von mehreren Candela, wurden weiße LEDs durch die teilweise Konversion des blauen Lichts mit YAG:Ce bzw. YAGaG:Ce realisiert, da die gelb-orange Emissionsfarbe dieser Leuchtstoffe komplementär zur blauen Emissionsfarbe der LEDs ist, und damit additiv weißes Licht erhalten werden kann.
Bis heute enthalten alle kommerziell erhältlichen weißen LEDs einen blauemittierenden InGaN Chip, der mit einer Schicht aus YAG:Ce oder YAGaG:Ce bedeckt ist. Wesentliche Nachteile dieses Ansatzes ist einerseits die Abhängigkeit der Emissionsfarbe vom Blickwinkel, was eine Folge der nicht homogenen Beschichtung des Chips ist. Andererseits hängt bei einer Lichtquelle basierend auf einem dichromatischen Spektrum (blau + gelb-orange) die Farbwiedergabe von der Farbtemperatur ab und niedrige Farbtemperaturen (T_{c} < 5000 K) lassen sich nicht mit einer genügend hohen Farbwiedergabe (CRI > 80) realisieren.

Darum ist das gegenwärtig vorrangiges Ziel zur Erweiterung des Produktspektrums und zur Verbesserung der Farbwiedergabe weißen LEDs, die Realisierung trichromatischer LEDs. Dazu müssen grün- bzw. gelb- und rot-emittierende Leuchtstoffe mit hoher Absorption im blauen Spektralbereich, mit hoher Quantenausbeute und einem hohem Lumenäquivalent bereitgestellt werden.

Eine Reihe von geeigneten rot-emittierenden Leuchtstoffen, wie z.B. (Ca,Sr)S:Eu, (Ca,Sr,Ba)₂Si₅N₈:Eu und (Ca,Sr)AlSiN₃:Eu bzw. Mischungen dieser Luminophore wurden hierzu schon in einer Vielzahl von Patentanmeldungen vorgeschlagen.

Ein Nachteil der bisher eingesetzten rot emittierenden Leuchtstoffe ist deren relative geringe Stabilität, was teilweise auf die Hydrolyseempfindlichkeit der sulfidischen bzw. nitridischen Wirtsgitter und teilweise auf die Redoxlabilität des Eu²⁺ Aktivators zurückzuführen ist. Zudem ist das Lumenäquivalent mit 200 - 270 lm/W aufgrund der breiten Emissionsbande nicht so hoch, wie man es von Eu³⁺-Leuchtstoffen mit 280 - 360 lm/W kennt. Daher geht die Suche nach effizienten und stabilen rot emittierenden Leuchtstoffen für LEDs mit hohem Lumenäquivalent unvermindert weiter.

Aus US 2003/178632 sind Granat-Leuchtstoffe der Seltenerdmetalle des allgemeinen Typs (Gd, Tb, La, Lu, Y)₃(Al, Ga)₅O₁₂:(Ce, Eu, Nd, Er, Cr, Mn) bekannt. Granat-Leuchtstoffe gemäß der vorliegenden Erfindung, die sowohl Mangan wie auch Calcium enthalten, sind nicht offenbart.

Aus WO 2007/144060 sind Granat-Leuchtstoffe der Seltenerdmetalle des allgemeinen Typs (Y, Gd, Lu, Tb)₃(Al, Ga)₅O₁₂:Ce bekannt. Granat-Leuchtstoffe gemäß der vorliegenden Erfindung, die sowohl Mangan wie auch Calcium enthalten, sind nicht offenbart.

Aufgabe der vorliegenden Erfindung war es, Lutetium-haltige Granat-Leuchtstoffe zu entwickeln, die eine rote Lumineszenz aufweisen und sich besonders für den Einsatz in Hochleistungs-pcLEDs zur Erzeugung warmweißen Lichtes eignen.

Überraschenderweise wurde nun gefunden, dass Mn⁴⁺- aktivierte Lutetium-haltige-Granat-Leuchtstoffe die oben genannte Aufgabe erfüllen.

Dabei muss der Einbau von vierwertigem Mangan auf dem Gitterplatz des dreiwertigen Aluminiums ausgeglichen werden durch den Einbau eines zweiwertigen Ions, wie Ca²⁺ oder Sr²⁺ auf dem Lu³⁺-Platz.

Eine erste Ausführungsform der vorliegenden Erfindung ist daher eine Verbindung der Formel I,

Lu_{3-x-z}AₓAl_{5-y-z}Sc_{y}O₁₂: Mn_{z}Ca_{z} (I)

wobei
A steht für Y, Gd oder Tb
x steht für einen Wert aus dem Bereich von 0 bis 2,90
y steht für einen Wert aus dem Bereich von 0 bis 0,50
z steht für einen Wert aus dem Bereich von 0,005 bis 0,05.

Vorzugsweise steht x für einen Wert aus dem Bereich 0 bis 2,0 und insbesondere bevorzugt aus dem Bereich 0,10 bis 0,90.
Vorzugsweise steht y für einen Wert aus dem Bereich 0,10 bis 0,45, insbesondere bevorzugt aus dem Bereich 0,20 bis 0,40.

Im Folgenden werden die erfindungsgemäßen Verbindungen der Formel I auch vereinfacht als Leuchtstoffe bezeichnet.

Erfindungsgemäße Leuchtstoffe in geringen Mengen eingesetzt ergeben bereits gute LED-Qualitäten. Die LED-Qualität wird dabei über übliche Parameter, wie beispielsweise den Color Rendering Index oder den Farbpunkt in CIE x und CIE y Koordinaten beschrieben.

Der Color Rendering Index oder CRI ist eine dem Fachmann geläufige, einheitslose lichttechnische Größe, welche die Farbwiedergabetreue einer künstlichen Lichtquelle mit derjenigen des Sonnenlichtes bzw. Filamentlichtquellen vergleicht (die beiden letztgenannten besitzen einen CRI von 100).

CIE x und CIE y stehen für die Koordinaten im dem dem Fachmann geläufigen CIE Normfarbdiagramm (hier Normalbeobachter 1931), mit denen die Farbe einer Lichtquelle beschrieben wird.
Alle oben aufgeführten Größen werden nach dem Fachmann geläufigen Methoden aus Emissionsspektren der Lichtquelle berechnet.

Im Kontext dieser Anmeldung wird als rotes Licht solches Licht bezeichnet, dessen Intensitätsmaximum zwischen 600 und 680 nm Wellenlänge liegt.

Ein weiterer Erfindungsgegenstand ist ein Verfahren zur Herstellung einer Verbindung der Formel I umfassend folgende Schritte:
a) Mischen von Lutetium-, Scandium-, Calcium-, Aluminium-, Mangan-, Yttrium-, Terbium- und/oder Gadolinium-haltigen Materialien
b) Zugabe mindestens eines weiteren anorganischen und/oder organischen Stoffes
c) thermische Behandlung der Mischung.

Bei der oben genannten thermischen Behandlung erfolgt die Umsetzung üblicherweise bei einer Temperatur oberhalb 800°C. Vorzugsweise erfolgt die thermische Behandlung in einem Mehrstufenprozess, besonders bevorzugt in einem 2-stufigen Prozess, d.h. zuerst wird bei einer Temperatur > 900°C unter Luft kalziniert und anschließend vorzugsweise bei einer Temperatur > 1500°C, besonders bevorzugt bei T = 1600 bis 1800°C. Alternativ kann die Kalzinierung auch unter reduzierenden Bedingungen (z.B. mit Kohlenmonoxid, Formiergas oder Wasserstoff oder Sauerstoffmangel-Atmosphäre) durchgeführt werden.

Als anorganischer oder organischer Stoff (im Schritt b) wird ein Stoff aus der Gruppe der Ammoniumhalogenide, Erdalkalifluoride wie Calcium-, Strontium- oder Bariumfluorid, (Erd)-Alkalimetallborate, Borsäure, (Erd)Alkalimetallcarbonate oder Ammoniumhydrogencarbonat, Citronensäure, Alkoholate sowie Oxalate und/oder Kieselsäureester wie z.B. TEOS eingesetzt. Bevorzugt wird Citronensäure und ein Oxalat zugesetzt. Gegebenenfalls kann das Oxalat auch schon im Schritt a) zugesetzt werden.

Die Herstellung der erfindungsgemäßen Leuchtstoffe kann entweder über eine herkömmliche Festkörperdiffusionsmethode (ausgehend von den Oxiden, Nitraten, Carbonaten oder Halogeniden der entsprechenden Erdalkalimetalle, Halbmetalle, Metalle oder Seltenerden) oder nasschemisch aus anorganischen und/oder organischen Metall- und/oder Seltenerd-Salzen mittels Sol-Gel-Verfahren, Copräzipitations- und /oder Trocknungsverfahren erfolgen. Bevorzugt sind erfindungsgemäß nasschemische Verfahren, besonders bevorzugt nasschemisch mittels Zugabe von Zitronensäure.

Bei den nasschemischen Verfahren über wässrige Vorstufen (Precursoren) der Leuchtstoffe sind folgende Methoden bekannt:
- Cofällung (auch Copräzipitation genannt) mit einer NH₄HCO₃-Lösung *(siehe z.B.* Jander, Blasius Lehrbuch der analyt. u. präp. anorg. Chem. 2002*)*
- Pecchini-Verfahren mit einer Lösung aus Zitronensäure und Ethylenglykol (*siehe z.B.* Annual Review of Materials Research Vol. 36: 2006, 281-331*)*
- Combustion-Verfahren unter Verwendung von Harnstoff
- Sprühtrocknung wässriger oder organischer Salzlösungen (Edukte)
- Sprühpyrolyse (auch Spraypyrolyse genannt) wässriger oder organischer Salzlösungen (Edukte)
- Eindampfen von Nitratlösungen und thermischer Umsetzung des Rückstandes
- Fällung mit einer Lösung, die Zitronensäue oder Oxalat enthält

Bei der o.g. Cofällung werden z.B. Chloridlösungen der entsprechenden Leuchtstoffedukte mit einer TEOS/NH₄HCO₃-Lösung versetzt, wodurch sich der Leuchtstoffprecursor bildet, der anschließend durch eine ein- oder mehrstufige thermische Behandlung in den Leuchtstoff umgewandelt wird.

Beim Pecchini-Verfahren werden z.B. Nitratlösungen der entsprechenden Leuchtstoffedukte bei Raumtemperatur mit einem Fällungsreagenz bestehend aus Zitronensäure und Ethylenglykol versetzt und anschließend erhitzt. Durch Erhöhung der Viskosität kommt es zur Leuchtstoffprecursor-Bildung.

Beim bekannten Combustion-Verfahren werden z.B. Nitratlösungen der entsprechenden Edukte in Wasser gelöst, dann unter Rückfluss gekocht und mit Harnstoff versetzt, wodurch sich der Leuchtstoffprecursor langsam bildet.

Die Sprühpyrolyse gehört zu den Aerosolverfahren, die durch Versprühen von Lösungen, Suspensionen oder Dispersionen in einen durch unterschiedliche Art und Weise erhitzten Reaktionsraum (Reaktor) sowie die Bildung und Abscheidung von Feststoff- Partikeln gekennzeichnet sind. Im Gegensatz zur Sprühtrocknung mit Heißgastemperaturen < 200°C finden bei der Sprühpyrolyse als Hochtemperatur-Prozess außer der Verdampfung des Lösungsmittels zusätzlich die thermische Zersetzung der verwendeten Edukte (z. B. Salze) sowie die Neubildung von Stoffen (z. B. Oxide, Mischoxide) statt.

Bei der Fällung mit einer Lösung aus Zitronensäure oder Oxalat werden z.B. Oxide oder Carbonatlösungen der entsprechenden Edukte in konz. HNO₃ gelöst und anschließend mit der o.g. Lösung versetzt, bevor dann eingedampft oder filtriert wird. Diese Methode ist erfindungsgemäß bevorzugt.

Die ersten sechs der o.g. Verfahrensvarianten sind ausführlich in der WO2007/144060 (Merck) beschrieben, die voll umfänglich in den Kontext der vorliegenden Anmeldung durch Bezugnahme eingefügt wird.

Die erfindungsgemäßen orange-rot-emittierenden Leuchtstoffe können auch mit grün-emittierenden Leuchtstoffen gemischt werden, wodurch sich solche Mischungen sehr gut für Anwendungen in der Allgemeinbeleuchtung (z.B. für warm-weiße LEDs) und LCD-backlighting eignen.

Eine weitere Ausführungsform der vorliegenden Erfindung ist daher eine Mischung enthaltend mindestens eine Verbindung der Formel I und mindestens einen grün-emittierenden Leuchtstoff, wobei dieser vorzugsweise ausgewählt wird aus Ce-dotierten Granaten, vorzugsweise LuAG:Ce, (Sr,Ca)Si₂N₂O₂:Eu, (Sr,Ba)₂SiO₄:Eu, oder CaSc₂O₄:Ce,Na.

Dabei liegen erfindungsgemäß die Verbindung (bzw. Leuchtstoff) gemäß Formel I und der mindestens eine grün emittierende Leuchtstoff üblicherweise im Gewichtsverhältnis 20:1 bis 1:1 vor. Erfindungsgemäß bevorzugt ist es, wenn der mindestens eine Leuchtstoff der Formel I und der mindestens eine grün emittierende Leuchtstoff im Gewichtsverhältnis 10:1 bis 3:1 und insbesondere bevorzugt 6:1 bis 4:1 vorliegen.

Die Partikelgröße der erfindungsgemäßen Leuchtstoffe beträgt üblicherweise zwischen 50 nm und 30 µm, vorzugsweise zwischen 1 µm und 20 µm.

In einer weiteren bevorzugten Ausführungsform besitzen die Leuchtstoffe in Partikelform eine geschlossene Oberflächenbeschichtung, die aus SiO₂, TiO₂, Al₂O₃, ZnO, ZrO₂ und/oderY₂O₃ oder Mischoxiden daraus besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächenbeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn die Leuchtstoffe eine poröse Oberflächenbeschichtung besitzen, die aus SiO₂, TiO₂, Al₂O₃, ZnO, ZrO₂ und/oder Y₂O₃ oder Mischoxide daraus oder aus der Leuchtstoffzusammensetzung besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Ausführungsform besitzen die Leuchtstoffpartikel eine Oberfläche, die funktionelle Gruppen trägt, welche eine chemische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Da die auf einem LED Chip aufgebrachte Leuchtstoffschicht vorzugsweise aus einem Gemisch von Silikon und homogenen Leuchtstoffpartikeln besteht, welches im Volumenguss aufgebracht wird, und das Silikon eine Oberflächenspannung aufweist, ist diese Leuchtstoffschicht auf mikroskopischer Ebene nicht einheitlich bzw. ist die Dicke der Schicht nicht durchweg konstant. Dies ist in der Regel auch der Fall wenn der Leuchtstoff nicht nach dem Volumengussverfahren, sondern im sogenannten Chip-Level-Konversionsverfahren, bei dem eine hochkonzentrierte, dünne Leuchtstoffschicht mit Hilfe von elektrostatischen Methoden direkt auf die Oberfläche des Chips appliziert wird, aufgebracht wird.

Mit Hilfe des oben genannten Verfahrens können beliebige äußere Formen der Leuchtstoffpartikel hergestellt werden, wie sphärische Partikel, Plättchen und strukturierte Materialien und Keramiken.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und DE 102006054331 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂-, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem anderen Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht. Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1: 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.
Die dem LED Chip zugewandte Oberfläche des erfindungsgemäßen plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.
Hierfür eignen sich beispielsweise brechzahlangepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der erfindungsgemäßen Leuchtstoffe in Form von keramischen Körpern erfolgt analog nach dem in der DE 102006037730 (Merck) beschriebenen Verfahren, die voll umfänglich in den Kontext der vorliegenden Anmeldung durch Bezugnahme eingefügt wird. Dabei wird der Leuchtstoff durch Mischen der entsprechenden Edukte und Dotierstoffe nasschemisch hergestellt, anschließend isostatisch verpresst und in Form eines homogenen dünnen und nicht porösen Plättchens direkt auf die Oberfläche des Chips aufgebracht. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneiden der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.
Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.
Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Die Anregbarkeit der erfindungsgemäßen Leuchtstoffe erstreckt sich zudem über einen weiten Bereich, der von etwa 410 nm bis 530 nm, bevorzugt 430 nm bis zu etwa 500 nm reicht. Damit sind diese Leuchtstoffe nicht nur zur Anregung durch violett oder blau emittierende Lichtquellen wie LEDs oder konventionelle Entladungslampen (z.B. auf Hg-Basis) geeignet, sondern auch für Lichtquellen wie solche, welche die blaue In³⁺ -Linie bei 451 nm ausnutzen.

Ein weiterer Gegenstand der vorliegenden Erfindung ist eine Lichtquelle, dadurch gekennzeichnet, dass diese einen Halbleiter und mindestens eine Verbindung bzw. einen Leuchtstoff nach Formel I enthält.

Ein weiterer Gegenstand der vorliegenden Erfindung ist eine Lichtquelle dadurch gekennzeichnet, dass diese einen Halbleiter und mindestens eine Verbindung nach Formel I sowie mindestens einen grün emittierenden Leuchtstoff enthält. Vorzugsweise ist diese Beleuchtungseinheit weiß emittierend oder emittiert Licht mit einem bestimmten Farbpunkt (Color-on-demand-Prinzip).

Unter dem color-on-demand Konzept versteht man die Realisierung von Licht eines bestimmten Farbpunktes mit einer pcLED (= phosphor converted LED) unter Einsatz eines oder mehrer Leuchtstoffe. Dieses Konzept wird z.B. verwendet, um bestimmte Corporate Designs, z.B. für beleuchtete Firmenlogos, Marken etc. zu erzeugen.

In einer bevorzugten Ausführungsform der erfindungsgemäßen Lichtquelle handelt es sich bei dem Halbleiter um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.

In einer weiteren bevorzugten Ausführungsform der erfindungsgemäßen Lichtquelle handelt es sich bei der Lichtquelle um eine lumineszente auf ZnO, TCO (Transparent conducting oxide), ZnSe oder SiC basierende Anordnung oder auch um eine auf einer organischen lichtemittierenden Schicht basierende Anordnung (OLED).

In einer weiteren bevorzugten Ausführungsform der erfindungsgemäßen Lichtquelle handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Dem Fachmann sind mögliche Formen von derartigen Lichtquellen bekannt. Es kann sich hierbei um lichtemittierende LED-Chips unterschiedlichen Aufbaus handeln.

Die erfindungsgemäßen Leuchtstoffe können entweder in einem Harz dispergiert (z.B. Epoxy- oder Siliconharz), oder bei geeigneten Größenverhältnissen direkt auf der Lichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005) L649-L651.

Weitere Erfindungsgegenstände sind eine Beleuchtungseinheit, insbesondere zur Hintergrundbeleuchtung von Anzeigevorrichtungen, die dadurch gekennzeichnet ist, dass sie mindestens eine oben beschriebene Lichtquelle enthält und entsprechende Anzeigevorrichtungen, insbesondere Flüssigkristallanzeigevorrichtung (LC Display), mit einer Hintergrundbeleuchtung, die dadurch gekennzeichnet sind, dass sie mindestens eine solche Beleuchtungseinheit enthalten.

Weiterhin bevorzugt ist eine Beleuchtungseinheit, insbesondere zur Allgemeinbeleuchtung, die dadurch gekennzeichnet ist, dass sie einen CRI (=color rendering index) > 60, vorzugsweise > 70, noch bevorzugter >85 aufweist. CRI-Werte > 85 können allerdings nur realisiert werden, wenn der erfindungsgemäße rote Leuchtstoff nach Formel I zusätzlich mit grünen Leuchtstoffen in der LED kombiniert wird.

In einer weiteren Ausführungsform ist es bevorzugt, wenn die optische Ankopplung der Beleuchtungseinheit zwischen dem Leuchtstoff und dem Halbleiter durch eine lichtleitende Anordnung realisiert wird.
Dadurch ist es möglich, dass an einem zentralen Ort der Halbleiter installiert wird und dieser mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Lichtquelle angekoppelt ist, realisieren. Auf diese Weise ist es möglich, eine starke Lichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Leuchtstoffe zur teilweisen oder vollständigen Konversion der blauen oder im nahen UV-liegenden Emission einer Lumineszenzdiode.

Weiterhin bevorzugt ist die Verwendung der erfindungsgemäßen Leuchtstoffe zur Konversion der blauen oder im nahen UV-liegenden Emission in sichtbare weiße Strahlung. Weiterhin ist die Verwendung der erfindungsgemäßen Leuchtstoffe zur Konversion der Primärstrahlung in einen bestimmten Farbpunkt nach dem "Color on demand"-Konzept bevorzugt.

Ein weiterer Gegenstand der vorliegenden Erfindung ist die Verwendung der erfindungsgemäßen Leuchtstoffe in Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelbgrünen Bereich emittieren. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und kommerziell erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

### Beispiele

### Beispiel 1: Herstellung von Lu₂₉₉₅Al_{4.995}O₁₂: Mn_{0.005}Ca_{0.005}

5,0125 g (0,0126 mol) Y₂O₃, 0,0042g CaCO₃ (4,2115*10⁻⁵ mol) und 0,0075g (4,2115*10⁻⁵ mol) MnC₂O₄*2H₂O werden in konz. HNO₃ unter Erwärmen gelöst. Zu dieser Lösung werden 15,7827 g (0,0427 mol) Al(NO₃)₃*9H₂O in 300 mL Wasser gegeben und anschließend 10g Citronensäure, wobei 30 Min. gerührt wird. Die Lösung wird im Trockenschrank bei 150°C über Nacht getrocknet und der entstandene Citratprecursor fein gemörsert. Das Pulver wird bei 1000°C für 3 h kalziniert und dann 5 h an Luft bei 1750°C kalziniert.

### Beispiel 2: Herstellung von Lu_{2.995}Al_{4.495}Sc_{0.5}O₁₂:Mn_{0.005}Ca_{0.005}

5,0125 g Lu₂O₃ und 0.5808 g Sc₂O₃ werden in konz. HNO₃ unter Erwärmen gelöst und dann wird 0.0042 g CaCO₃ zugegeben.
14.2028 Al(NO₃)₃*9H₂O und 0.0075 g Manganoxalat werden in dest. Wasser gelöst und zu der vorherigen Lösung gegeben.
Zu dieser Lösung werden 10 g Citronensäure gegeben und unter Erwärmen 30 min gerührt. Die Lösung wird im Trockenschrank bei 130 °C über Nacht eingeengt und der entstandene Citratprecursor fein gemörsert. Das Pulver wird bei 1000°C 3 h kalziniert und dann 4 h bei 1700°C an Luft kalziniert.

### Beispiel 3: Herstellung von Lu_{1.4975}Y₁.₄₉₇₅Al₄,₉₉₅ O₁₂:Mn_{0.005}Ca_{0.005}

2,507 g Lu₂O₃ und 1,4226 g Y₂O₃ werden in konz. HNO₃ unter Erwärmen gelöst und 4,2 mg CaCO₃ werden zugegeben. 15,783 g Al(NO₃)₃*9H₂O und 7,5 mg Manganoxalat werden in dest. Wasser gelöst und zu der vorherigen Lösung gegeben. In diese Lösung werden 10 g Citronensäure gegeben und unter Erwärmen 30 min gerührt. Die Lösung wird im Trockenschrank bei 130°C über Nacht eingeengt und der entstandene Citratprecursor gemörsert. Das Pulver wird bei 1000°C für 3 h kalziniert und dann für 4 h bei 1700°C an Luft kalziniert

### Beispiel 4: Herstellung von Lu_{1.4975}Gd_{1.4975}Al₄,₉₉₅O₁₂:Mn_{0.005}Ca_{0.005}

23.507 g Lu₂O₃ und 2,284 g Gd₂O₃ werden in konz. HNO₃ unter Erwärmen gelöst, dann werden 4,2 mg CaCO₃ zu dieser Lösung gegeben.
15,783 g Al(NO₃)₃*9H₂O und 7,5 mg Manganoxalat werden in dest. Wasser gelöst und zu der vorherigen Lösung gegeben. In diese Lösung werden 10 g Menge Citronensäure gegeben und unter Erwärmen 30 min gerührt. Die Lösung wird im Trockenschrank bei 130°C über Nacht eingeengt und der entstandene Citratprecursor gemörsert. Das Pulver wird bei 1000 °C für 3 h kalziniert und dann 4 h bei 1700°C an Luft kalziniert

### Beispiel 5: Herstellung einer Leuchtdiode

Ein Leuchtstoff aus den Beispielen 1 bis 4 wird in einem Taumelmischer mit einem 2-Komponenten Silikon (OE6550 der Fa. Dow Corning) gemischt, so dass gleiche Mengen des Leuchtstoffs in den beiden Komponenten des Silikons dispergiert sind, die Gesamtkonzentration der Leuchtstoffmischung im Silikon beträgt 8 Gew.-%.

5 ml jeder der beiden Leuchtstoff enthaltenden Silikon Komponenten werden homogen miteinander gemischt und in einen Dispenser überführt. Mit Hilfe des Dispensers werden leere LED packages von der Fa. OSA optoelectronics, Berlin, welche einen 100 µm² großen GaN Chip enthalten, befüllt. Danach werden die LEDs in eine Wärmekammer gestellt, um über 1 h bei 150°C das Silikon zu verfestigen.

**Tab. 1 zeigt die optischen Eigenschaften der erfindungsgemäßen Leuchtstoffe**

| Zusammensetzung | Emissions -max [nm] | CIE 1931 |
|---|---|---|
| | 664 | X:0,713 |
| LU_{2,995}Ca_{0,005} Al₄,₉₉₅Mn_{0,005}O₁₂ | 637 | Y:0,283 |
| Lu_{2.995}Ca_{0.005}Al₄.₄₉₅Mn_{0.005}Sc₀.₅O₁₂ | 664 | X:0,713 |
| | 651 | Y:0,283 |
| | 637 | |
| Lu_{1.4975}Y_{1.4975}Ca_{0,005}Al_{4,995}Mn_{0,005}O₁₂ | 671 | X:0,720 |
| | 641 | Y:0,277 |
| LU₁.₄₉₇Gd_{1.4975}Ca_{0,005}Al_{4,995}Mn_{0,005}O₁₂ | 674 | X:0,717 |
| | | Y:0,282 |

CIE x und CIE y stehen für die Koordinaten in dem dem Fachmann geläufigen CIE Normfarbdiagramm (hier Normalbeobachter 1931), mit denen die Farbe einer Lichtquelle beschrieben wird.
Alle oben aufgeführten Größen werden nach dem Fachmann geläufigen Methoden aus Emissionsspektren der Lichtquelle berechnet.

### Beschreibung der Figuren

Es sei darauf hingewiesen, dass bei den nachfolgenden 16 FigurenBeschreibungen die Leuchtstoffzusammensetzungen jeweils durch die verkürzte Schreibweise angegeben sind, wie sie in der Laserphysik üblich sind. Das heißt z.B. Lu_{2.995}Al₄.₉₉₅O₁₂: Mn_{0.005}Ca_{0.005} wird in verkürzter Schreibweise als "Lu₃Al₅O₁₂: Mn⁴⁺(0,1%), Ca²⁺(0,1%)" angegeben.

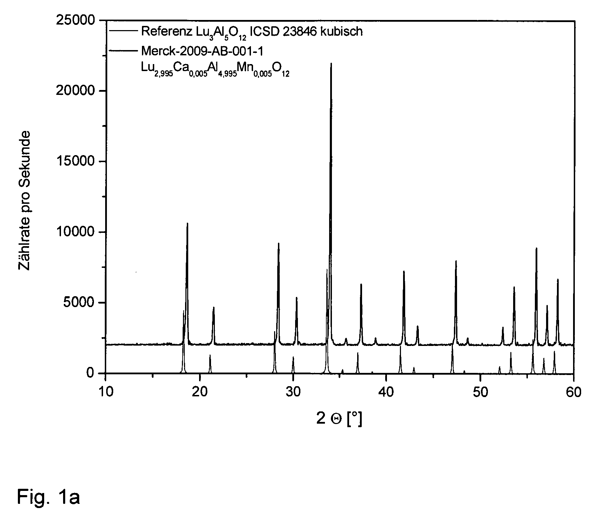

Fig. 1a: zeigt einen Vergleich der Röntgendiffraktogramme von Leuchtstoffen der Zusammensetzung Lu₃Al₅O₁₂: Mn⁴⁺(0,1%), Ca²⁺(0,1%) im Vergleich zu dem Diffraktogramm der Referenz Lu₃Al₅O₁₂. Die Röntgendiffraktogramme wurden mit einem Rigaku Miniflux II unter Verwendung von Cu-K-alpha-Strahlung aufgenommen. Der Messbereich 2Theta betrug 10 - 60°.

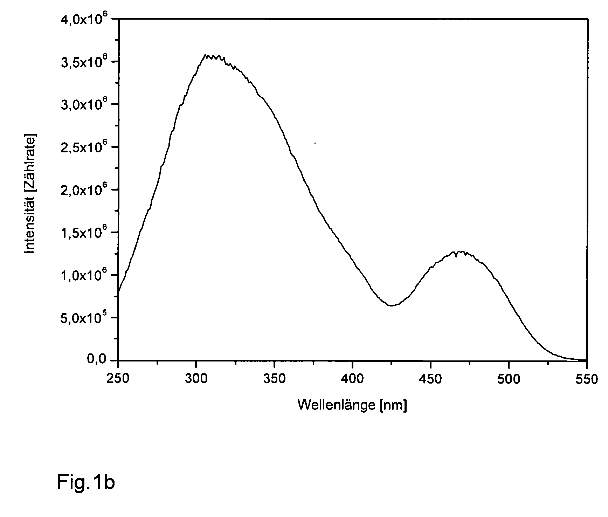

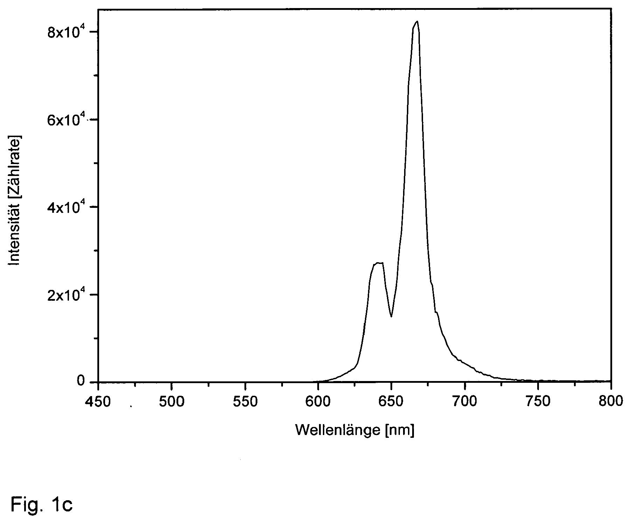

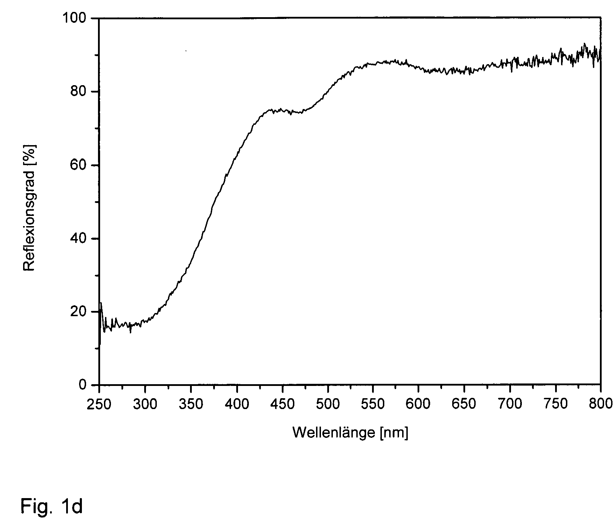

Fig. 1 b : zeigt ein Anregungsspektrum von Lu₃Al₅O₁₂: Mn⁴⁺(0,1%), Ca²⁺(0,1%) Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.
Fig. 1 c: zeigt das normierte Emissionsspektrum von Lu₃Al₅O₁₂: Mn⁴⁺(0,1%), Ca²⁺(0,1%). Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.
Fig. 1d: zeigt ein Reflexionsspektrum von Lu₃Al₅O₁₂: Mn⁴⁺(0,1%), Ca²⁺(0,1%)
   Das Spektrum wurden an einer halbunendlich dicken Pulverschicht mit einem Edinburgh Instruments FS920 Spektrometer in einer Ulbricht.-Kugel unter Verwendung einer Xe-Hochdrucklampe und eines Hamamatsu Photomultipliers bei Raumtemperatur aufgenommen.

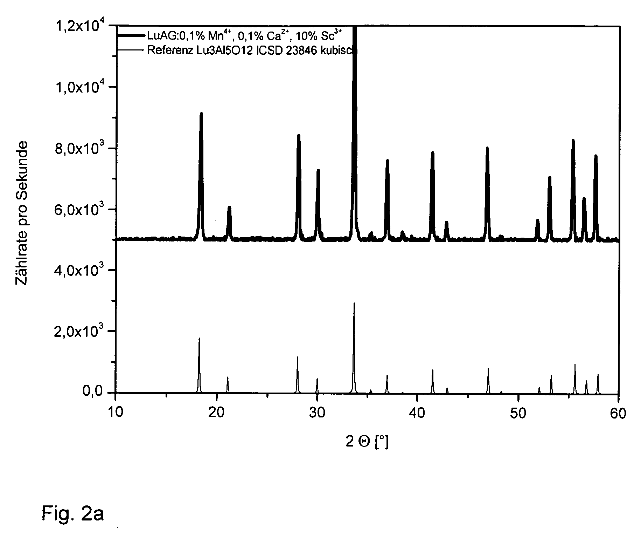

Fig. 2a: zeigt einen Vergleich der Röntgendiffraktogramme von Leuchtstoffen der Zusammensetzung Lu₃Al_{4.5}Sc_{0.5}O₁₂:Mn(0.1%),Ca(0.1 %) im Vergleich zu dem Diffraktogramm der Referenz Lu₃Al₅O₁₂. Die Röntgendiffraktogramme wurden mit einem Rigaku Miniflux II unter Verwendung von Cu-K-alpha-Strahlung aufgenommen. Der Messbereich 2Theta betrug 10 - 60°.

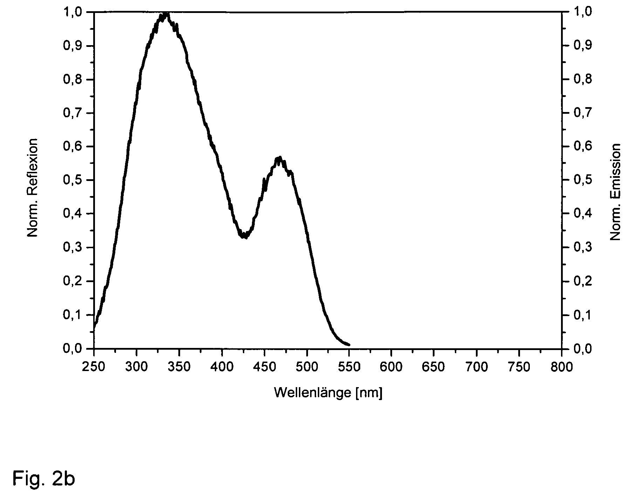

Fig. 2b : zeigt ein Anregungsspektrum von Lu₃Al₄.₅Sc₀.₅O₁₂:Mn(0.1%) ,Ca(0.1%). Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.

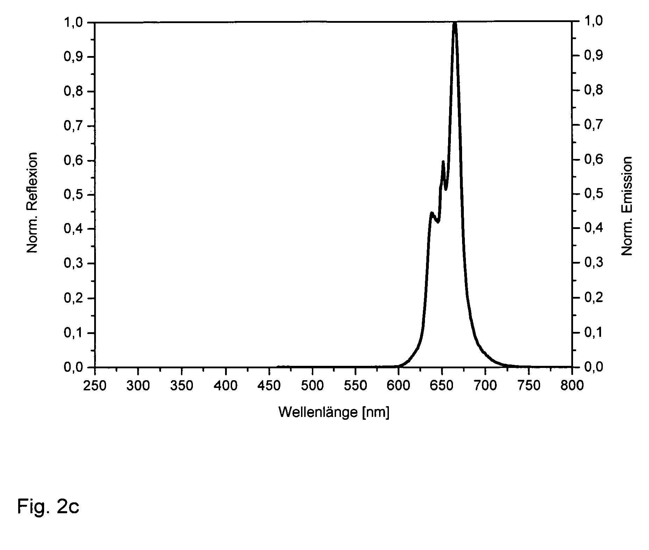

Fig. 2c: zeigt das normierte Emissionsspektrum von Lu₃Al₄.₅Sc₀.₅O₁₂:Mn(0.1%), Ca(0.1 %). Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.

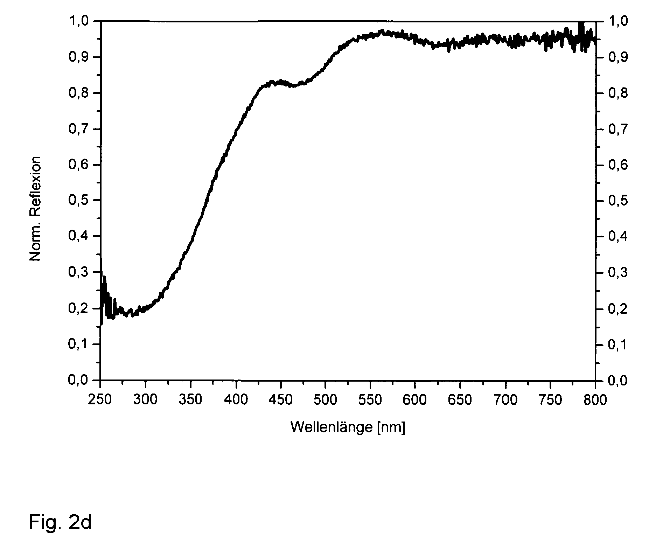

Fig. 2d: zeigt ein Reflexionsspektrum von Lu₃Al_{4.5}Sc_{0.5}O₁₂:Mn(0.1%), Ca(0.1 %). Das Spektrum wurden an einer halbunendlich dicken Pulverschicht mit einem Edinburgh Instruments FS920 Spektrometer in einer Ulbricht.-Kugel unter Verwendung einer Xe-Hochdrucklampe und eines Hamamatsu Photomultipliers bei Raumtemperatur aufgenommen.

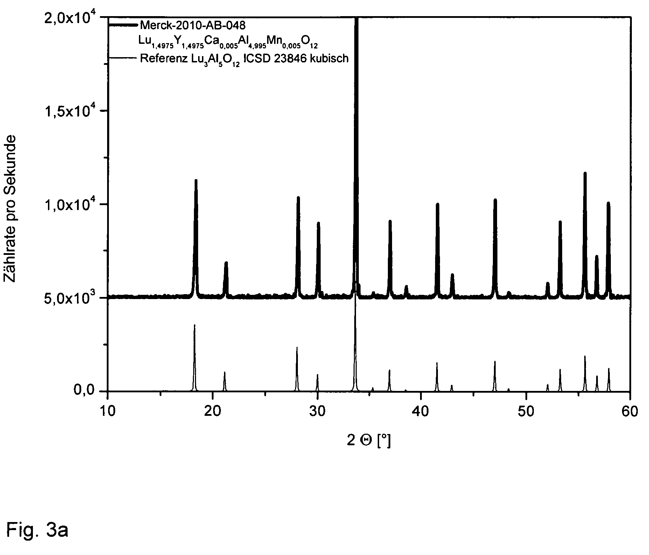

Fig. 3a: zeigt einen Vergleich der Röntgendiffraktogramme von Leuchtstoffen der Zusammensetzung (Lu_{0.5}Y_{0.5})₃Al₅O₁₂:Mn(0.1%), Ca(0.1 %) im Vergleich zu dem Diffraktogramm der Referenz Lu₃Al₅O₁₂. Die Röntgendiffraktogramme wurden mit einem Rigaku Miniflux II unter Verwendung von Cu-K-alpha-Strahlung aufgenommen. Der Messbereich 2Theta betrug 10 - 60 °.

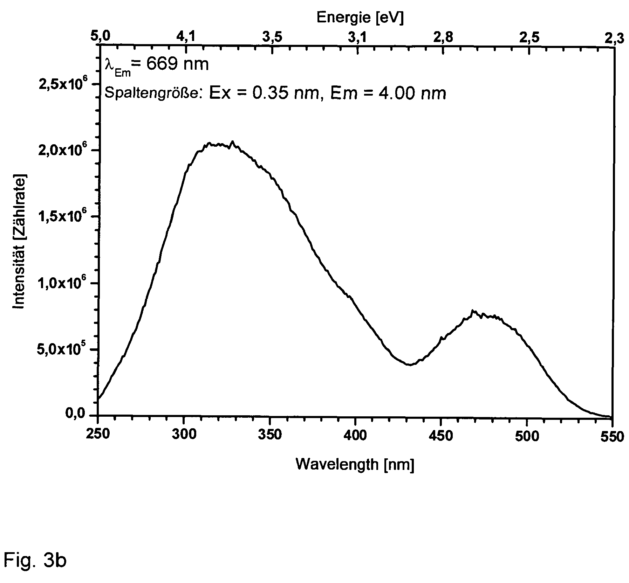

Fig. 3b : zeigt ein Anregungsspektrum von (Lu_{0.5}Y₀.₅)₃Al₅O₁₂:Mn(0.1%) Ca(0.1%). Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.

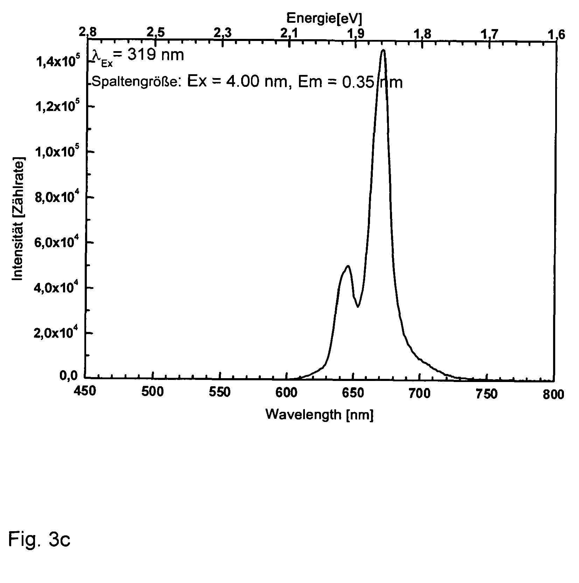

Fig. 3c: zeigt das normierte Emissionsspektrum von (Lu₀.₅Y_{0.5})₃Al₅O₁₂:Mn(0.1%),Ca(0.1%). Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.

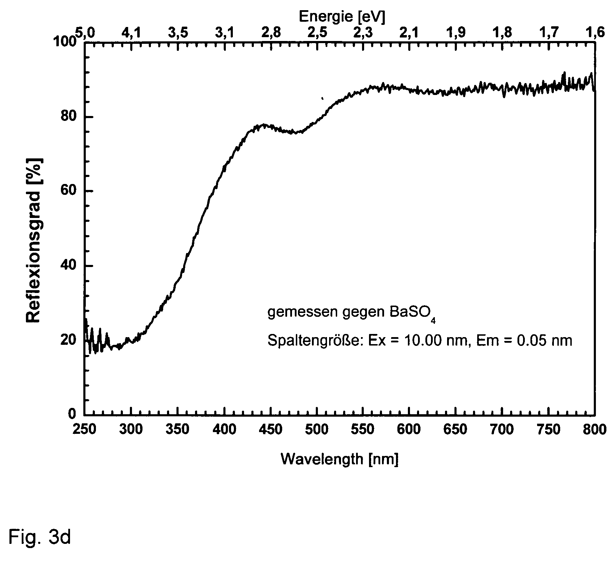

Fig. 3d: zeigt ein Reflexionsspektrum von (Lu_{0.5}Y_{0.5})₃Al₅O₁₂:Mn(0.1%), Ca(0.1 %). Das Spektrum wurden an einer halbunendlich dicken Pulverschicht mit einem Edinburgh Instruments FS920 Spektrometer in einer Ulbricht.-Kugel unter Verwendung einer Xe-Hochdrucklampe und eines Hamamatsu Photomultipliers bei Raumtemperatur aufgenommen.

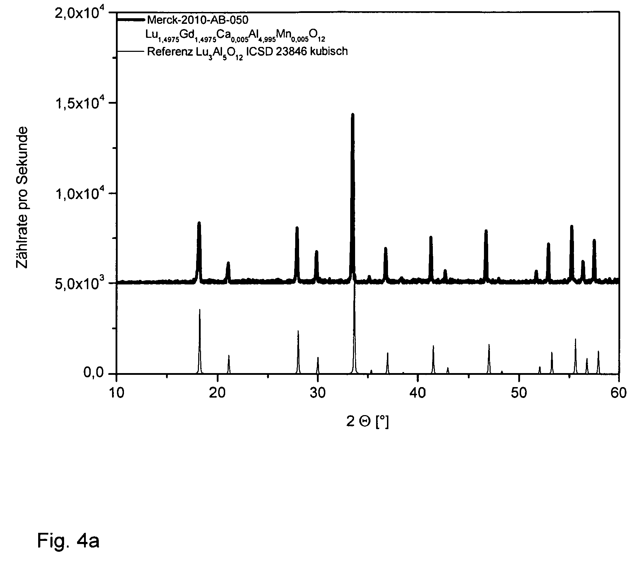

Fig. 4a: zeigt einen Vergleich der Röntgendiffraktogramme von Leuchtstoffen der Zusammensetzung (Lu_{0.5}Gd_{0.5})₃Al₅O₁₂:Mn(0.1%), Ca(0.1 %) im Vergleich zu dem Diffraktogramm der Referenz Lu₃Al₅O₁₂. Die Röntgendiffraktogramme wurden mit einem Rigaku Miniflux II unter Verwendung von Cu-K-alpha-Strahlung aufgenommen. Der Messbereich 2Theta betrug 10 - 60°.

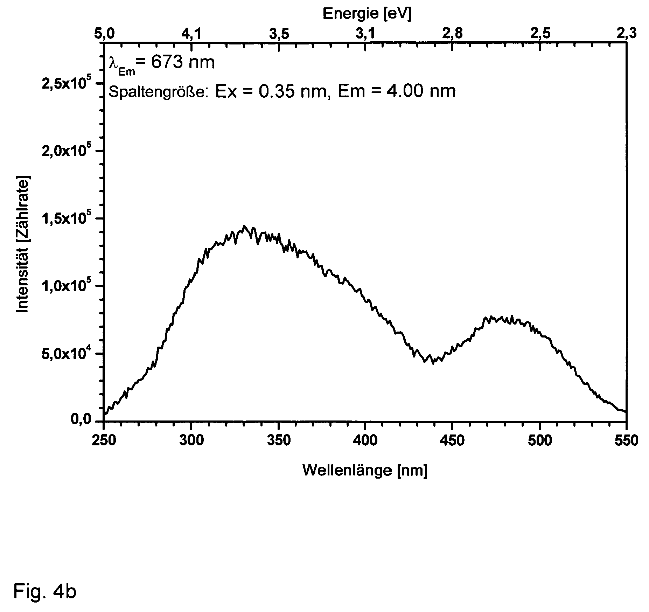

Fig. 4b : zeigt ein Anregungsspektrum von (Lu_{0.5}Gd_{0.5})₃Al₅O₁₂:Mn(0.1%), Ca(0.1%). Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.

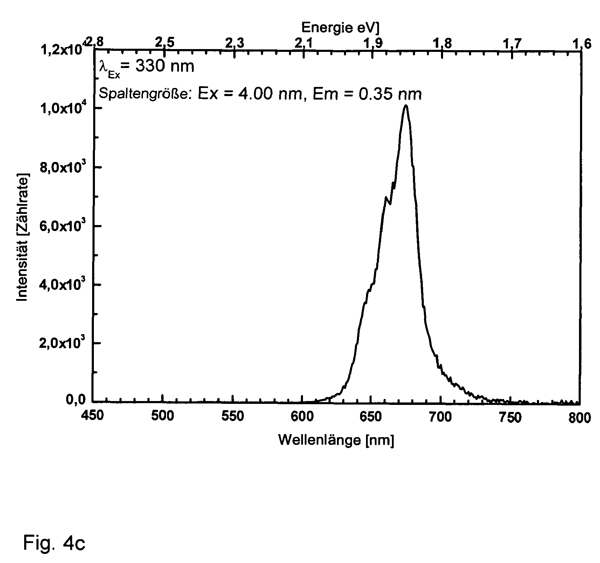

Fig. 4c: zeigt das normierte Emissionsspektrum von (Lu_{0.5}Gd_{0.5})₃Al₅O₁₂:Mn(0.1%),Ca(0.1%). Das Spektrum wurden an einer halbunendlich dicken Pulverschicht mit einem Edinburgh Instruments FL920 Spektrometer unter Verwendung einer Xe-Hochdrucklampe und eines Hamamatsu Photomultipliers bei Raumtemperatur aufgenommen.

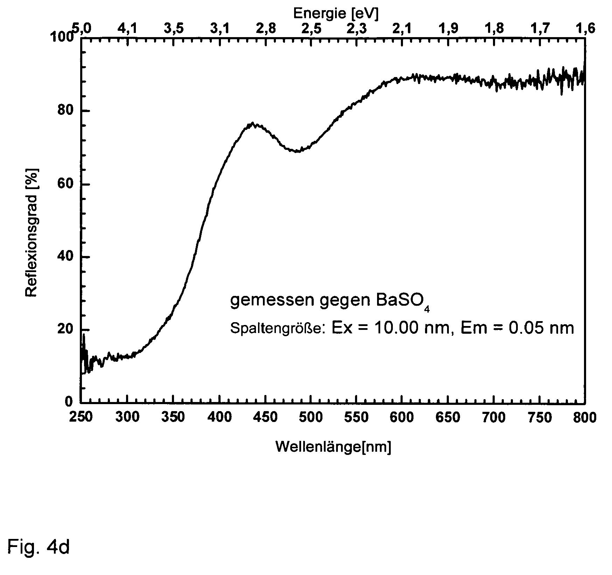

Fig. 4d: zeigt ein Reflexionsspektrum von (Lu_{0.5}Gd_{0.5})₃Al₅O₁₂:Mn(0.1%), Ca(0.1 %). Das Spektrum wurden an einer halbunendlich dicken Pulverschicht mit einem Edinburgh Instruments FS920 Spektrometer in einer Ulbricht.-Kugel unter Verwendung einer Xe-Hochdrucklampe und eines Hamamatsu Photomultipliers bei Raumtemperatur aufgenommen.

## Patentansprüche

1. Verbindung der Formel I
Lu_{3-x-Z}AₓAl_{5-y-z}Sc_{y}O₁₂: Mn_{z}Ca_{z} (I)
wobei
A steht für Y, Gd oder Tb
x steht für einen Wert aus dem Bereich von 0 bis 2,90
y steht für einen Wert aus dem Bereich von 0 bis 0,50
z steht für einen Wert aus dem Bereich von 0,005 bis 0,05.

2. Verbindung nach Anspruch 1, **dadurch gekennzeichnet, dass** x steht für einen Wert aus dem Bereich von 0 bis 2,0, vorzugsweise aus dem Bereich von 0,10 bis 0,90.

3. Verbindung nach Anspruch 1 oder 2, **dadurch gekennzeichnet, dass** y steht für einen Wert aus dem Bereich von 0,10 bis 0,45, vorzugsweise aus dem Bereich von 0,20 bis 0,40.

4. Verfahren zur Herstellung einer Verbindung nach einem oder mehreren der Ansprüche 1 bis 3 umfassend folgende Verfahrensschritte:
a) Mischen von Lutetium-, Scandium-, Calcium-, Aluminium-, Mangan-, Yttrium-, Terbium- und/oder Gadolinium-haltigen Materialien,
b) Zugabe mindestens eines weiteren anorganischen und/oder organischen Stoffes,
c) thermische Behandlung der Mischung.

5. Verfahren nach Anspruch 4, **dadurch gekennzeichnet, dass** die anorganischen oder organischen Stoffe (Verfahrenschritt b) ausgewählt werden aus der Gruppe der Ammoniumhalogenide, Erdalkalifluoride, wie Calcium-, Strontium- oder Bariumfluorid, (Erd)Alkalimetallborate, Borsäure, (Erd)Alkalimetallcarbonate oder Ammoniumhydrogencarbonat, Citronensäure, Alkoholate sowie Oxalate und/oder Kieselsäureester wie z.B. TEOS.

6. Verfahren nach Anspruch 4 und/oder 5, **dadurch gekennzeichnet, dass** die thermische Behandlung der Mischung mehrstufig, vorzugsweise 2-stufig abläuft.

7. Lichtquelle, **dadurch gekennzeichnet, dass** diese einen Halbleiter und mindestens eine Verbindung nach Formel I gemäß einem oder mehreren der Ansprüche 1 bis 3 enthält.

8. Lichtquelle nach Anspruch 7, **dadurch gekennzeichnet, dass** es sich bei dem Halbleiter um ein lumineszentes IndiumAluminiumGalliumNitrid, insbesondere der Formel InᵢGaⱼAl*ₖN, wobei 0 ≤ i, 0 ≤ j, 0 ≤ k, und i+j+k=1 handelt.

9. Beleuchtungseinheit, **dadurch gekennzeichnet, dass** sie mindestens eine Lichtquelle nach den Ansprüchen 7 oder 8 enthält.

10. Beleuchtungseinheit nach Anspruch 9, **dadurch gekennzeichnet, dass** die optische Ankopplung zwischen dem Leuchtstoff und dem Halbleiter durch eine lichtleitende Anordnung realisiert ist.

11. Anzeigevorrichtung, insbesondere Flüssigkristallanzeigevorrichtung (LC Display), **dadurch gekennzeichnet, dass** sie mindestens eine Beleuchtungseinheit nach Anspruch 9 oder 10 enthält.

12. Verwendung von mindestens einer Verbindung nach einem oder mehreren der Ansprüche 1 bis 3 als Konversionsleuchtstoff zur teilweisen oder vollständigen Konversion der blauen oder im nahen UV-liegenden Emission einer Lumineszenzdiode.

## Claims

1. Compound of the formula I
LU_{3-x-z} AₓAl_{5-y-z}SC_{y}O₁₂: Mn_{z}Ca_{z} (I)
where
A stands for Y, Gd or Tb
x stands for a value from the range from 0 to 2.90
y stands for a value from the range from 0 to 0.50
z stands for a value from the range from 0.005 to 0.05.

2. Compound according to Claim 1, **characterised in that** x stands for a value from the range from 0 to 2.0, preferably from the range from 0.10 to 0.90.

3. Compound according to Claim 1 or 2, **characterised in that** y stands for a value from the range from 0.10 to 0.45, preferably from the range from 0.20 to 0.40.

4. Process for the preparation of a compound according to one or more of Claims 1 to 3 comprising the following process steps:
a) mixing of lutetium-, scandium-, calcium-, aluminium-, manganese-, yttrium-, terbium- and/or gadolinium-containing materials,
b) addition of at least one further inorganic and/or organic substance,
c) thermal treatment of the mixture.

5. Process according to Claim 4, **characterised in that** the inorganic or organic substances (process step b) are selected from the group of the ammonium halides, alkaline-earth metal fluorides, such as calcium fluoride, strontium fluoride or barium fluoride, alkaline-earth or alkali-metal borates, boric acid, alkaline-earth or alkali-metal carbonates or ammonium hydrogencarbonate, citric acid, alcoholates, as well as oxalates and/or silicates, such as, for example, TEOS.

6. Process according to Claim 4 and/or 5, **characterised in that** the thermal treatment of the mixture is carried out in multiple steps, preferably in 2 steps.

7. Light source, **characterised in that** it comprises a semiconductor and at least one compound of the formula I according to one or more of Claims 1 to 3.

8. Light source according to Claim 7, **characterised in that** the semiconductor is a luminescent indium aluminium gallium nitride, in particular of the formula InᵢGajAlₖN, where 0 ≤ i, 0 ≤ j, 0 ≤ k, and i+j+k=1.

9. Lighting unit, **characterised in that** it contains at least one light source according to Claim 7 or 8.

10. Lighting unit according to Claim 9, **characterised in that** the optical coupling between the phosphor and the semiconductor is achieved by a light-conducting arrangement.

11. Display device, in particular liquid-crystal display device (LC display), **characterised in that** it contains at least one lighting unit according to Claim 9 or 10.

12. Use of at least one compound according to one or more of Claims 1 to 3 as conversion phosphor for the partial or complete conversion of the blue or near-UV emission from a luminescent diode.

## Revendications

1. Composé de la formule I :
Lu_{3-x-z} AₓAl_{5-y-z}Sc_{y}O₁₂: Mn_{z}Ca_{z} (I)
dans laquelle :
A représente Y, Gd ou Tb
x représente une valeur dans la plage de 0 à 2,90
y représente une valeur dans la plage de 0 à 0,50
z représente une valeur dans la plage de 0,005 à 0,05.

2. Composé selon la revendication 1, **caractérisé en ce que** x représente une valeur dans la plage de 0 à 2,0, de façon préférable dans la plage de 0,10 à 0,90.

3. Composé selon la revendication 1 ou 2, **caractérisé en ce que** y représente une valeur dans la plage de 0,10 à 0,45, de façon préférable dans la plage de 0,20 à 0,40.

4. Procédé pour la préparation d'un composé selon une ou plusieurs des revendications 1 à 3, comprenant les étapes de procédé qui suivent :
a) mélange de matériaux contenant du lutétium, du scandium, du calcium, de l'aluminium, du manganèse, de l'yttrium, du terbium et/ou du gadolinium,
b) ajout d'au moins une autre substance inorganique et/ou organique,
c) traitement thermique du mélange.

5. Procédé selon la revendication 4, **caractérisé en ce que** les substances inorganiques ou organiques (étape de procédé b) sont choisies parmi le groupe comprenant les halogénures d'ammonium, les fluorures de métaux des terres alcalines, tels que le fluorure de calcium, le fluorure de strontium ou le fluorure de baryum, les borates de métaux des terres alcalines ou de métaux alcalins, l'acide borique, les carbonates de métaux des terres alcalines ou de métaux alcalins ou l'hydrogènecarbonate d'ammonium, l'acide citrique, les alcoolates, de même que les oxalates et/ou les silicates, tels que, par exemple, de l'orthosilicate de tétraéthyle (TEOS).

6. Procédé selon la revendication 4 et/ou 5, **caractérisé en ce que** le traitement thermique du mélange est mis en oeuvre selon de multiples étapes, de façon préférable selon 2 étapes.

7. Source de lumière, **caractérisée en ce qu'**elle comprend un semiconducteur et au moins un composé de la formule I selon une ou plusieurs des revendications 1 à 3.

8. Source de lumière selon la revendication 7, **caractérisée en ce que** le semiconducteur est un nitrure d'indium aluminium gallium luminescent, en particulier de la formule InᵢGaⱼAlₖN, dans laquelle 0 ≤ i, 0 ≤ j, 0 ≤ k, et i+j+k=1.

9. Unité d'éclairage, **caractérisée en ce qu'**elle contient au moins une source de lumière selon la revendication 7 ou 8.

10. Unité d'éclairage selon la revendication 9, **caractérisée en ce que** le couplage optique entre le phosphore et le semiconducteur est réalisé au moyen d'un agencement de conduction de lumière.

11. Dispositif d'affichage, en particulier dispositif d'affichage à cristaux liquides (affichage LC), **caractérisé en ce qu'**il contient au moins une unité d'éclairage selon la revendication 9 ou 10.

12. Utilisation d'au moins un composé selon une ou plusieurs des revendications 1 à 3 en tant que phosphore de conversion pour la conversion partielle ou complète de l'émission de bleu ou des UV proches en provenance d'une diode luminescente.
